# EUROPEAN PATENT APPLICATION

(11) **EP 3 214 486 A1**
(43) Date of publication of application: **06.09.2017**
(21) Application number: 15795094.0
(22) Date of filing: 16.03.2015
(51) Int. Cl.: G02F 1/1333, G02F 1/1335

(54) **COA SUBSTRATE AND MANUFACTURING METHOD THEREOF, AND DISPLAY DEVICE**

(30) Priority: 31.10.2014 CN 201410602704
(71) Applicant: BOE Technology Group Co., Ltd., Beijing 100015 (CN)
(72) Inventor: ZHANG, Feng, Beijing 100176 (CN); YAO, Qi, Beijing 100176 (CN); CAO, Zhanfeng, Beijing 100176 (CN)
(74) Representative: Gesthuysen Patent- und Rechtsanwälte
(86) International application number: PCT/CN2015/074280
(87) International publication number: WO 2016/065796

(57) **Abstract**

The present invention provides a COA substrate and a method for manufacturing the same, as well as a display device, and relates to the field of display technology, which solves the problem of impossible alignment of the pattern of the black matrix with that of a front layer structure thereof in the COA substrate during the formation of the black matrix, enhances the display quality of the display device and avoids production of defective display devices. The COA substrate comprises a black matrix, wherein the material of the black matrix is an infrared-permeable material, and an aligning light source for aligning the pattern of the black matrix with that of the front layer thereof is infrared. The present invention is applied to the technology of manufacturing display means.

## Description

### Cross-Reference to Related Applications

The present invention claims the benefit of Chinese Patent Application No. 201410602704.6, filed on October 31, 2014, the entire invention of which is incorporated herein by reference.

### Technical Field

The invention relates to the field of display technology, and more particularly to a COA substrate and method for manufacturing the same, as well as a display device.

### Background Art

Display means, such as a liquid crystal display (LCD) and an organic electroluminescent device (OLED), are necessities in human lives. With the improvement of people's needs, a technology of integrating a color filter with an array substrate, namely Color Filter on Array (COA), came into being so as to enhance the display quality of the display device, and avoid the issue of aperture ratio and light leakage of the display device as a result of a deviation when box aligning the array substrate with the color film substrate. The COA technology is to arrange a black matrix and a color filter on an array substrate.

The current black matrix is usually made of a resin encapsulating soot particles. Since the soot particles can absorb lights, the black matrix is able to shield lights in a better manner. In the technology of COA, since the black matrix is arranged on the array substrate, it is required to align the pattern of the layer structure of the black matrix with that of its front layer structure when forming the black matrix layer structure. The black matrix, however, can absorb lights, so the pattern of the front layer structure becomes invisible after the coating of the black matrix, thereby making it impossible to align the pattern of the black matrix with that of its front layer structure. For this reason, the display quality of the display device will be influenced, and even the finally formed display devices cannot be used and become defective products.

### Summary of the Invention

The embodiment of the present invention provides a COA substrate and a method for manufacturing the same, as well as a display device, which solves the problem of impossible alignment of the pattern of the black matrix with that of a front layer structure thereof in the COA substrate during the formation of the black matrix, enhances the display quality of the display device and avoids production of defective display devices.

To this end, an embodiment of the present invention adopts the following technical solution:

In the first aspect, a COA substrate is provided, which comprises a black matrix, wherein:
the material of the black matrix is an infrared-permeable material, and
an aligning light source for aligning the pattern of the black matrix with that of the front layer thereof is infrared.

Alternatively, the COA substrate further comprises a first passivation layer formed on the substrate, wherein
the black matrix is formed on the first passivation layer.

Alternatively, the COA substrate further comprises a resin flat layer and a color filter, wherein:
the color filter is formed in a position of the black matrix that covers the substrate, and the color filter is covered by the resin flat layer.

Alternatively, the material of the black matrix includes a resin material having red, green and blue pigments or a black resin.

Alternatively, the black matrix has a thickness ranging from 2µm to 4µm and an optical density per unit thickness ranging from 1µm to 2µm.

In the second aspect, a display device is provided, which comprises any COA substrate as recited in the first aspect.

In the third aspect, a method for manufacturing a COA substrate is provided, which comprises the step of
forming, on the substrate, a black matrix of an infrared-permeable material and by means of alignment using an aligning light source capable of transmitting infrared.

Alternatively, the method further comprises the steps of:
forming, on the black matrix, a color filter that covers the substrate; and
forming, on the color filter, a resin flat layer that covers the color filter.

Alternatively, the method further comprises the step of forming a first passivation layer on the substrate, and the step of forming, on the substrate, a black matrix of an infrared-permeable material and by means of alignment using an aligning light source capable of transmitting infrared comprises the steps of:
forming a layer of film of the infrared-permeable material on the first passivation layer;
aligning with the pattern of the front layer of the black matrix by the aligning light source capable of transmitting infrared, and treating the film by a patterning process to form the black matrix.

Alternatively, the method further comprises the step of:
receiving the lights transmitted by the aligning light source and permeable to the black matrix by an induction device capable of receiving infrared.

Alternatively, the material of the black matrix includes a resin material having red, green and blue pigments or a black resin.

Alternatively, the black matrix has a thickness ranging from 2µm to 4µm and an optical density per unit thickness ranging from 1µm to 2µm.

As to the COA substrate and the method for manufacturing the same, as well as the display device according to the embodiment of the present invention, a black matrix is formed of an infrared-permeable material, and meanwhile infrared is used to align the black matrix with its front layer structure, in such a manner that it is possible to see aligning marks on the black matrix and its front layer structure during formation of the black matrix, and achieve accurate aligning of the pattern of the black matrix with that of its front layer structure, which solves the existing problem of impossible alignment of the pattern of the black matrix with that of a front layer structure thereof in the COA substrate during the formation of the black matrix, enhances the display quality of the display device and avoids production of defective display devices, and meanwhile reduces production cost.

### Brief Description of Drawings

To explain the embodiments of the present invention or technical solutions in the prior art more clearly, the drawings used in the description of the embodiments or the prior art will be briefly introduced as follows. Apparently, the drawings as described below are only for illustrating some embodiments of the present invention. Those skilled in the art can obtain other drawings according to these drawings without making any inventive effort.
Fig. 1 is a structural schematic view of a COA substrate according to one embodiment of the present invention;
Fig. 2 is a structural schematic view of another COA substrate according to another embodiment of the present invention;
Fig. 3 is a flow-chart schematic view of a method for manufacturing a COA substrate according to a further embodiment of the present invention;
Fig. 4 is a flow-chart schematic view of a further method for manufacturing a COA substrate according to a yet embodiment of the present invention; and
Fig. 5 is a schematic view showing the transmittance spectrum comparison between an embodiment of the present invention and the prior-art black matrix.

Reference signs: 1-substrate; 2-gate; 3-gate insulating layer; 4-active layer; 5-source; 6-drain; 7-first passivation layer; 8-black matrix; 9-resin flat layer; 10-color filter; 11-common electrode layer; 12-second passivation layer; 13-pixel electrode layer.

### Detailed Description of the Invention

The technical solutions of the embodiments of the present invention will be further described clearly and completely with reference to the drawings thereof. It is apparent that the embodiments described herein are only a portion of, not all of, the embodiments of the present invention. All the other embodiments obtained by those skilled in the art based on the embodiments of the present invention without making any inventive effort fall within the protection scope of the present invention.

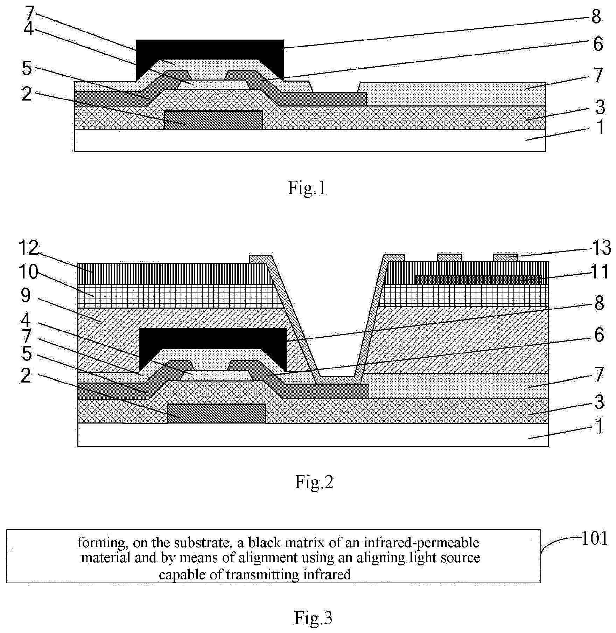

An embodiment of the present invention provides a COA substrate. With reference to Fig. 1, the COA substrate comprises a substrate 1, a gate 2, a gate insulating layer 3, an active layer 4, a source 5, a drain 6, a first passivation layer 7 formed on the source 5 and the drain 6, and the COA substrate further comprises a black matrix 8, wherein:
a feasible solution is that the black matrix 8 is formed in a position of the first passivation layer 7 that covers the source 5 and the drain 6 to render them partially exposed.

Wherein the black matrix is positioned on the source and the drain to cover a portion thereof only, in which the normal display of the COA substrate functions to shield lights normally. What needs to be explained is that the present embodiment is only to examplify the position of the black matrix, rather than impose any limitations thereon.

Wherein the material of the black matrix 8 is an infrared-permeable material.

An aligning light source used for aligning the pattern of the black matrix 8 with that of the front layer of the black matrix is infrared.

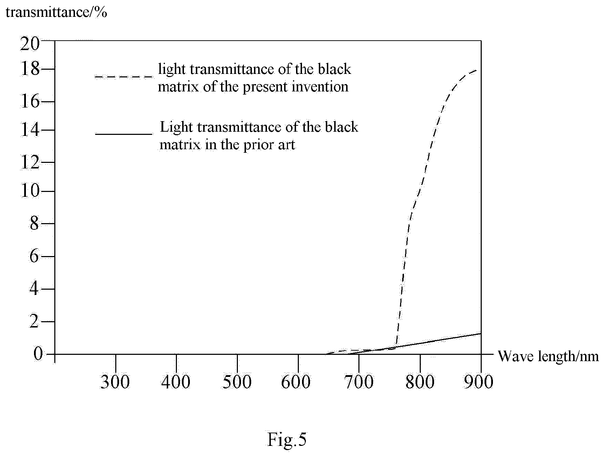

To be specific, the black matrix in an embodiment of the present invention is made of a material that is infrared-permeable and has a good light-absorptive property within a visible band, and an infrared spectrum serves as an aligning light source when aligning the pattern of the black matrix with that of its front layer structure, such as the source and the drain. In comparasion with the prior-art black matrix made of a material that has a light-absorptive property within a whole brand, aligning marks are visible during alignment of the black matrix, in such a manner that the patterns of the black matrix and its front layer structure can be accurately aligned, which ensures formation of the black matrix in an accurate position and achieves the light absorpition function of the black matrix without influencing the normal display of the display device. Fig. 5 is a schematic view showing the transmittance spectrum comparison between an embodiment of the present invention and the prior-art black matrix. The black matrix in the illustrated embodiment has a light density of 4. As known from the drawing, the black matrix of the present invention has a high transmittance when the length of optical waves is within a corresponding infrared band, thereby rendering it possible to achieve the above technical object and corresponding technical effects.

Preferably, the infrared aligning light source (namely, infrared that is permeable to the black matrix) is near infrared with a wave band preferably ranging from 780nm to 1100nm. In a preferable emboidment, the optical density of the black matrix is 4 (for instance, the optical density per unit thickness of the material of the black matrix is 1µm to 2µm, and the thickness of the black matrix is 2µm to 4µm), the wave length of the infrared aligning light source (namely, infrared that is permeable to the black matrix) is selected as 900nm, under which conditions the transmittance of infrared can be up to over 10%, thereby achieving an optimal effect.

Wherein the substrate can be a glass substrate or quartz substrate; the gate, the source and the drain can be formed from a metal material; the gate insulating layer can be formed of silicon nitride, silicon oxide, or silicon oxynitride; the active layer can be formed of a metal oxide semiconductor material; and the first passivation layer can be made of silicon nitride or transparent organic resin.

As to the COA substrate according to the embodiment of the present invention, a black matrix is formed of an infrared-permeable material, and meanwhile infrared is used to align the black matrix with its front layer structure, in such a manner that it is possible to see aligning marks on the black matrix and its front layer structure during formation of the black matrix, and achieve accurate aligning of the pattern of the black matrix with that of its front layer structure, which solves the existing problem of impossible alignment of the pattern of the black matrix with that of a front layer structure thereof in the COA substrate during the formation of the black matrix, enhances the display quality of the display device, avoids production of defective display devices, and meanwhile reduces production cost.

Moreover, as shown in Fig. 2, the COA substrate further comprises a resin flat layer 9 and a color filter 10, wherein:
the color filter 10 is formed in a position of the black matrix 8 that covers the substrate 1, and the color filter 10 is covered by the resin flat layer 9.

What needs to be explained is that as shown in Fig. 2, the COA substrate further comprises a common electrode layer 11, a second passivation layer 12 and a pixel electrode layer 13.

Wherein the material of the black matrix includes a resin material having red, green and blue pigments or a black resin.

The black matrix has a thickness ranging from 2µm to 4µm.

To be specific, the black matrix in the present embodiment has a thickness ranging from 2µm to 4µm and an optical density per unit thickness ranging from 1µm to 2µm, so as to ensure that the formed black matrix can absorb visible lights well, thereby achieving a light-absorptive function of the black matrix, and meanwhile that the infrared lights are permeable to the black matrix, thereby rendering the aligning marks visible during the alignment of the black matrix.

Meanwhile, the black matrix in an embodiment of the present invention is usually formed of a resin material having red, green and blue pigments or a black resin. In comparison with the prior-art black matrix formed of soot particles, the black matrix of the present invention has a relatively small dielectric constant and higher resistivity, a better electrical property, such as a voltage holding ratio, and an improved TFT property, so that the formed display device has a better performance.

The aligning light source and the induction device for receiving the lights transmitted by the aligning light source according to the present embodiment can be installed in an exposure device. The exposure device can be such suitably modified that the aligning light source transmits infrared and the induction device can receive an infrared spectrum transmitted by the aligning light source.

As to the COA substrate according to the embodiment of the present invention, a black matrix is formed of an infrared-permeable material, and meanwhile infrared is used to align the black matrix with its front layer structure, in such a manner that it is possible to see aligning marks on the black matrix and its front layer structure during formation of the black matrix, and achieve accurate aligning of the pattern of the black matrix with that of its front layer structure, which solves the existing problem of impossible alignment of the pattern of the black matrix with that of a front layer structure thereof in the COA substrate during the formation of the black matrix, enhances the display quality of the display device, avoids production of defective display devices, and meanwhile reduces production cost.

An embodiment of the present invention provides a display device, which comprises a COA substrate according to an embodiment of the present invention.

As to the display device according to the embodiment of the present invention, a black matrix in the display device is formed of an infrared-permeable material, and meanwhile infrared is used to align the black matrix with its front layer structure, in such a manner that it is possible to see aligning marks on the black matrix and its front layer structure during formation of the black matrix, and achieve accurate aligning of the pattern of the black matrix with that of its front layer structure, which solves the existing problem of impossible alignment of the pattern of the black matrix with that of a front layer structure thereof in the COA substrate during the formation of the black matrix, enhances the display quality of the display device, avoids production of defective display devices, and meanwhile reduces production cost.

An embodiment of the present invention provides a method for manufacturing a COA substrate. With reference to Fig. 3, the method comprises the step of:
101. forming, on the substrate, a black matrix of an infrared-permeable material and by means of alignment using an aligning light source capable of transmitting infrared.

To be specific, the black matrix is made of a material to which infrared lights are permeable but visible lights are not permeable, and has a light-shielding function. The black matrix can be made by radiation using an alighing light source and by alignment using aligning marks on a first passivation layer.

As to the method for manufacturing a COA substrate according to the embodiment of the present invention, a black matrix is formed of an infrared-permeable material, and meanwhile infrared is used to align the black matrix with its front layer structure, in such a manner that it is possible to see aligning marks on the black matrix and its front layer structure during formation of the black matrix, and achieve accurate aligning of the pattern of the black matrix with that of its front layer structure, which solves the existing problem of impossible alignment of the pattern of the black matrix with that of a front layer structure thereof in the COA substrate during the formation of the black matrix, enhances the display quality of the display device, avoids production of defective display devices, and meanwhile reduces production cost.

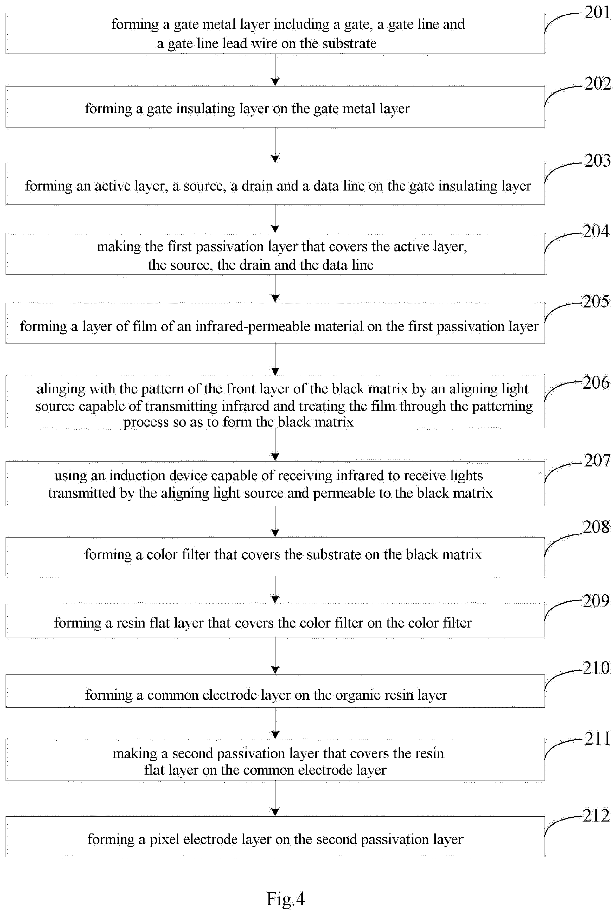

An embodiment of the present invention provides a method for manufacturing a COA substrate. With reference to Fig. 4, the method comprises the step of:
201. forming a gate metal layer including a gate, a gate line and a gate line lead wire on the substrate.

To be specific, a layer of metal film with a thickness ranging from 1000Å to 7000Å is deposited on the substrate, such as a glass substrate or a quartz substrate, by means of magnetron sputtering. The metal film is usually made of a metal selected from the group consisting of molybdenum, aluminium, aluminium-nickel alloy, molybdenum-tungsten alloy, chromium or copper, or a combination of films made of the above materials. Then, the gate metal layer is formed on a certain area of the substrate by a mask plate using a patterning process such as exposure, developing, etching and peeling.

202. forming a gate insulating layer on the gate metal layer.

To be specific, a film of the gate insulating layer with a thickness ranging from 1000Å to 6000Å is deposited on the glass substrate by means of chemical vapor deposition or magnetron sputtering. The film of the gate insulating layer is usually made of silicon nitride, but silicon oxide or silicon oxynitride can also be used.

203. forming an active layer, a source, a drain and a data line on the gate insulating layer.

To be specific, a metal oxide semiconductor film is deposited on the gate insulating layer by means of chemical vapor deposition, then the metal oxide semiconductor film is treated by the patterning process to form the active layer, i.e., after photoresist is applied, the substrate is exposed, developed and etched using a typical mask plate to form the active layer.

Further, similar to the method for manufacturing the gate line, a metal film with a thickness ranging from 1000Å to 7000Å, which is similar to a gate metal, is deposited on the substrate, on the certain area of which the source, the drain and the data line are formed by means of the patterning process.

204. making the first passivation layer that covers the active layer, the source, the drain and the data line.

To be specific, similar to the method for making the gate insulating layer and the active layer, the first passivation layer with a thickness of 1000Å to 6000Å is applied over the substrate, and the material thereof is usually silicon nitride or transparent organic resin.

205. forming a layer of film of an infrared-permeable material on the first passivation layer.

To be specific, a material to which infrared lights are permeable but visible lights are not permeable is coated over the first passivation layer to form a layer of film, the material of which is usually a resin having red, green and blue pigments or a black resin capable of absorbing visible lights.

206. alinging with the pattern of the front layer of the black matrix by an aligning light source capable of transmitting infrared and treating the film through the patterning process so as to form the black matrix.

To be specific, the aligning light source capble of transmitting infrared is used to transmit infrared, and the infrared lights permeable to the film which forms the black matrix are radiated onto the first passivation layer to render the aligning marks on the first passivation layer visible, and the black matrix formed in a position of the first passivation layer that covers the source and the drain to render them partially exposed is treated by the patterning process according to the aligning marks.

207. using an induction device capable of receiving infrared to receive lights transmitted by the aligning light source and permeable to the black matrix.

What needs to be explained is that step 207 and step 206 can be performed simultaneously. The order for performing the steps is not specifially defined in the present embodiment, but dependent on the particular manufacturing process in practical use.

208. forming a color filter that covers the substrate on the black matrix.

209. forming a resin flat layer that covers the color filter on the color filter.

210. forming a common electrode layer on the organic resin layer.

To be specific, a layer of ITO or IZO with a thickness ranging from 300Å to 500Å is deposited by means of magnetron sputtering and then forms the common electrode layer after exposure, developing and etching.

211. making a second passivation layer that covers the resin flat layer on the common electrode layer.

To be specific, similar to the method for making the gate insulating layer and the active layer, the passivation layer is applied over the substrate, and the material thereof is usually silicon nitride or transparent organic resin.

212. forming a pixel electrode layer on the second passivation layer.

The ITO or IZO is deposited on the second passivation layer by means of magnetron sputtering and then forms the pixel electrode layer after exposure, developing and etching.

As to the method for manufacturing the COA substrate according to the embodiment of the present invention, a black matrix is formed of an infrared-permeable material, and meanwhile infrared is used to align the black matrix with its front layer structure, in such a manner that it is possible to see aligning marks on the black matrix and its front layer structure during formation of the black matrix, and achieve accurate aligning of the pattern of the black matrix with that of its front layer structure, which solves the existing problem of impossible alignment of the pattern of the black matrix with that of a front layer structure thereof in the COA substrate during the formation of the black matrix, enhances the display quality of the display device, avoids production of defective display devices, and meanwhile reduces production cost.

The above description is only related to the embodiments of the present invention; however, the protection scope of the present invention is not limited thereto. Any skilled person in the art can readily conceive of various modifications or variants within the technical scope of the present invention. Hence, the protection scope of the present invention shall be based on that of the appending claims.

## Claims

1. A COA substrate, **characterized in that** the COA substrate comprises: a black matrix, wherein:
a material of the black matrix is an infrared-permeable material, and
an aligning light source for aligning the black matrix with a pattern of a front layer of the black matrix is infrared.

2. The COA substrate according to claim 1, **characterized in that** the COA substrate further comprises a first passivation layer formed on the substrate, wherein
the black matrix is formed on the first passivation layer.

3. The COA substrate according to claim 1 or 2, **characterized in that** the COA substrate further comprises a resin flat layer and a color filter, wherein:
the color filter is formed in a position of the black matrix that covers the substrate, and the color filter is covered by the resin flat layer.

4. The COA substrate according to claim 1 or 2, **characterized in that** the material of the black matrix includes a resin material having red, green and blue pigments or a black resin.

5. The COA substrate according to claim 1 or 2, **characterized in that** the black matrix has a thickness ranging from 2µm to 4µm and an optical density per unit thickness ranging from 1µm to 2µm.

6. A display device, **characterized in that** the display device comprises a COA substrate according to any one of claims 1 to 5.

7. A method for manufacturing a COA substrate, **characterized in that** the method comprises the step of
forming, on the substrate, a black matrix of an infrared-permeable material and by means of alignment using an aligning light source capable of transmitting infrared.

8. The method according to claim 7, **characterized in that** the method further comprises the steps of:
forming, on the black matrix, a color filter that covers the substrate; and
forming, on the color filter, a resin flat layer that covers the color filter.

9. The method according to claim 7 or 8, **characterized in that** the method further comprises the step of forming a first passivation layer on the substrate, and the step of forming, on the substrate, a black matrix of an infrared-permeable material and by means of alignment using an aligning light source capable of transmitting infrared comprises the steps of:
forming a layer of film of the infrared-permeable material on the first passivation layer;
aligning with the pattern of the front layer of the black matrix by the aligning light source capable of transmitting infrared, and treating the film by a patterning process to form the black matrix.

10. The method according to claim 9, **characterized in that** the method comprises the step of
receiving the lights transmitted by the aligning light source and permeable to the black matrix by an induction device capable of receiving infrared.

11. The method according to claim 7 or 8, **characterized in that** a material of the black matrix includes a resin material having red, green and blue pigments or a black resin.

12. The method according to claim 7 or 8, **characterized in that** the black matrix has a thickness ranging from 2µm to 4µm and an optical density per unit thickness ranging from 1µm to 2µm.
